# EUROPEAN PATENT SPECIFICATION

(11) **EP 2 162 389 B1**
(45) Date of publication and mention of the grant of the patent: **16.10.2013**
(21) Application number: 08770204.9
(22) Date of filing: 05.06.2008
(51) Int. Cl.: C01B 33/00, C23C 16/24, C23C 16/44, C23C 16/455

(54) **RECYCLE AND REUSE OF SILANE**
RÜCKFÜHRUNG UND WIEDERVERWENDUNG VON SILAN
RECYCLAGE ET RÉUTILISATION DE SILANE

(30) Priority: 07.06.2007 US 933835 P
(43) Date of publication of application: 17.03.2010
(73) Proprietor: Linde LLC, Murray Hill, NJ 07974 (US)
(72) Inventor: SAXENA, Neeraj, Murray Hill, NJ 07974 (US); MCMULLEN, Nigel, Long Valley, NJ 07853 (US); CUDDEBACK, Bruce, Somerset, NJ 08873 (US)
(74) Representative: Gellner, Bernd
(86) International application number: PCT/US2008/065924
(87) International publication number: WO 2008/154293

(56) References cited:
- EP-A1- 0 215 968
- US-A- 4 460 673
- US-A- 4 988 533
- US-A- 5 118 485
- US-A1- 2005 115 504
- US-B2- 6 512 171

## Description

### FIELD OF THE INVENTION

The present invention relates to new methods and apparatus for the recycle and reuse of silane, particularly as used in the manufacture of solar cells.

### BACKGROUND OF THE INVENTION

Silane and silane-hydrogen mixtures are used in the manufacture of solar cells, primarily for the deposition of silicon layers, as known from US Patent Number 4,460,673 and Patent applications US 2005/0115504 and EP 0215968. Generally, less than 10% and as little a 3% of the silane that flows through a plasma chamber to deposit the silicon is actually utilized, with the rest remaining unreacted. Hydrogen is often used as a diluent of the silane, in volume ratios of 4:1 to 10:1, during the deposition process and remains essentially unreacted throughout the process. In current solar cell manufacturing processes, the unreacted silane or silane/hydrogen mixture that exits the plasma chamber needs to be destroyed in a combustion chamber downstream of the plasma chamber, typically located after the exhaust pumps. However, this results in considerable wasted, i.e. unused and unreacted, silane and silane/hydrogen mixtures, what adds to the cost of solar cell fabrication.

It is clearly desirable to reduce the amount of waste silane by recycling and reusing the unreacted silane from the plasma chamber. However, there are a number of problems associated with such recycle and reuse. In particular, the silane used in the deposition process is often mixed with other gases that are used during solar cell fabrication; e.g. borane, phosphine, methylsilane, or methane, making separation and recovery of the silane difficult. Further, the flow rates of silane or silane mixed with hydrogen change drastically during the production cycle, varying from zero to maximum flow several times over a given time period. In addition, the silane gas phase reactions in the plasma can create a changed gas composition that can result in process control problems if the gases are recycled.

Therefore, there is a need in the art for improvements to the recycle and reuse of silane, particularly as used for solar cell manufacturing.

### SUMMARY OF THE INVENTION

The present invention provides a solution to the problems noted above and provides methods and apparatus for the recycle and reuse of silane and silane/hydrogen mixtures used in the production of thin film silicon layers as indicated in independent claims 1, 4 and 9, respectively, particularly for solar cell manufacture.
Preferred embodiments are indicated in the dependent claims.

In particular, the present invention relies on the fact that at specific time periods during the thin film silicon deposition process, only the silane containing gas (e.g. silane or disilane) either alone or as a mixture with hydrogen is flowing through the deposition chamber. In other words, there are times during the deposition process when there is no flow of any additional gas, such as boron, phosphorus or carbon containing gases. These time periods of silane flow can be identified and during such times, rather than directing the unreacted gases to a waste destruction unit, the unreacted gases are redirected to a collection vessel. During the times when the unreacted gases include additional components, e.g. boron, phosphorus, carbon, the unreacted gases are directed to the waste destruction unit in accordance with standard processing.

### BRIEF DESCRIPTION OF THE DRAWINGS

Figure 1 is a schematic view of a standard multi chamber PECVD system for manufacturing solar cells as know in the prior art.

Fig. 2 is a schematic view of a multi chamber PECVD system for manufacturing solar cells in accordance with an embodiment of the present invention.

Fig. 3 is a schematic view of a multi chamber PECVD system for manufacturing solar cells in accordance with another embodiment of the present invention.

### DETAILED DESCRIPTION OF PREFERRED EMBODIMENTS

The present invention provides a solution to the problems noted above with respect to the recycle and reuse of silane and silane/hydrogen mixtures as used in the production of thin film silicon layers, particularly for solar cell manufacture.

In the process of thin film silicon solar cell production, gases such as silane are flowed into a reaction chamber, at pressures of about (0.13-1333 Pa (0.001-10 Torr), and subjected to an energy source such as thermal, microwave or plasma, to cause a thin film of silicon to be deposited as required for the performance of the solar cell electronic device being produced. For example, LP-PECVD (low pressures plasma enhanced chemical vapor deposition) processes can be used in solar cell manufacturing. In order to build up the layers of the solar cell, several gases and mixtures are generally used in a series of deposition steps. Silane or silane/hydrogen mixtures are commonly used for depositing silicon layers, while silane mixed with other gases can be used to deposit layers of various composition. As noted above, less than 10% of the silane that flows into the reaction chamber is normally utilized. The unreacted silane must be purged from the deposition chamber, sometimes along with other gases and is normally destroyed in a chemical reaction away from the reaction chamber. The recycle and reuse of unreacted silane presents clearly desirable opportunities and advantages, but is not a trivial undertaking. In particular, to recycle and reuse silane, it is necessary to design a collection and recycle system that is economic, safe, reliable and has no adverse quality effects on the solar cells being formed.

The present invention provides all of these advantages. In particular, the present invention provides methods and apparatus that rely on specific time periods during the deposition process when only silane or silane/hydrogen mixtures are flowing through the deposition chamber. At these times it is possible to collect the silane or silane/hydrogen mixtures and recycle the collected gas for reuse in further deposition processes.

The present invention provides improved methods and apparatus for the deposition of thin film silicon solar cells. Typical deposition processes include the several stages. In particular, silane or disilane is flowed into one or more LP-PECVD chambers. The silane gas may be mixed with other gases such as hydrogen, Argon, nitrogen, phosphine, helium, diborane, etc., depending on the desired composition of the layer to be deposited. An energy source is then used to excite the gases and cause chemical vapor deposition of a silicon layer over a substrate in the chamber to form electronic devices. Excess unreacted gases are purged from the LP-PECVD chamber and in current processes are pumped or exhausted to a waste destruction unit where the unreacted gases are destroyed, or to a dilution system where the gases may be diluted with other gases. The use of multiple LP-PECVD chambers allows for increased throughput of solar cells.

The above process results in significant waste of silane. In particular, less than 10% of the silane flowing into the deposition chamber is actually utilized in depositing the layers. The present invention provides methods and apparatus for recycling and reusing at least a portion of this excess silane. In particular, the present invention identifies certain times during the deposition process when only the silane containing gas (e.g. silane or disilane) alone or as a mixture with hydrogen is flowing. During these times, no additional gas, such as boron, phosphorus or carbon containing gases are flowing or present in the deposition chamber. Therefore, in accordance with the present invention, during these time periods the silane is directed to a collection vessel rather than to the normal waste destruction unit. During times when additional component gases, e.g. boron, phosphorus, carbon, are present, the unreacted gases continue to be directed to the standard waste destruction unit.

In accordance with the present invention the collected silane or silane/hydrogen mixtures are compressed to a higher pressure using a pumping device such as a dry pump. This compression system must assure that there is no contact of the gases with the pump/sealing oils or with the cooling water. The higher pressure silane gas can then be recycled to the gas supply stream for the plasma reaction chambers. To ensure uniform gas composition being provided to the deposition chamber, the recycled gas may be mixed with fresh silane, hydrogen or both. In one embodiment of the present invention, the gases are returned to the gas supply stream using an ejector or venturi type device. In this embodiment, the hydrogen required for silane dilution during the deposition process is used as the motive force and therefore no additional gas is necessary.

The present invention is especially useful in processes utilizing multiple deposition chambers because the recovered silane gases from all of the process deposition can be mixed together for ease in further processing. In addition, recycle rates can be optimized so that the by-products of the plasma reactions in the reaction chamber do not build up during the deposition process.

The present invention allows for the recovery of 5% to 80% of the unreacted silane or silane/hydrogen gas mixtures. This provides an increase in overall silane utilization from less than 10% to 15% and possibly as much as 25%.

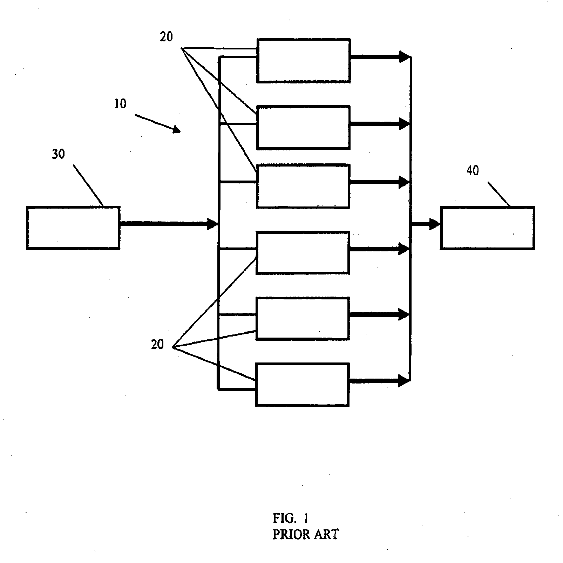

The present invention will be described in more detail with reference to the drawing figures. Figure 1 is a schematic view of a standard multi chamber PECVD system 10, for manufacturing solar cells as know in the prior art. In this system 10, multiple deposition chambers 20, each receive process gas, e.g. silane, silane/hydrogen mixtures, or silane mixed with other deposition gases, from a deposition gas source 30, in a particular sequence and flow pattern over time as required to deposit the desired silicon films making up the solar cell. The choice of sequence and deposition times is set by the manufacturer and therefore may be different for different manufacturing operations. All of the unreacted gases exit the deposition chambers 20, and are sent to a standard waste treatment unit 40, for disposal.

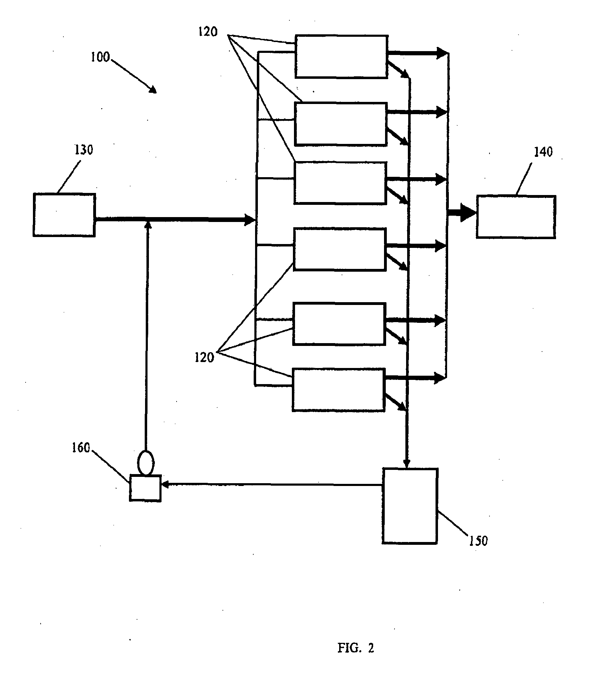

Figure 2 is a schematic view of a multi chamber PECVD system 100, for manufacturing solar cells in accordance with one embodiment of the present invention. In similar fashion to the standard deposition system depicted in Figure 1, multiple deposition chambers 120, each receive process gas, e.g. silane, silane/hydrogen mixtures, or silane mixed with other deposition gases, from a deposition gas source 130, in a particular sequence and flow pattern over time as required to deposit the desired silicon films making up the solar cell. As noted above the choice of sequence and deposition times may vary according to different manufacturing operations. At times identified in the operation when only silane or silane/hydrogen mixtures are exiting the deposition chambers 120, the off gas is sent to a collection unit 150, and then recycled for reuse in the deposition chambers 120. In this embodiment, the collected gas is pumped from the collection unit 150, back to the deposition chambers 120, using a dry pump 160. During time periods when other gases, e.g. boron, phosphorus, carbon, etc. are present in the off gas from the deposition chambers 120, then the off gas is sent to a standard waste treatment unit 140, for disposal.

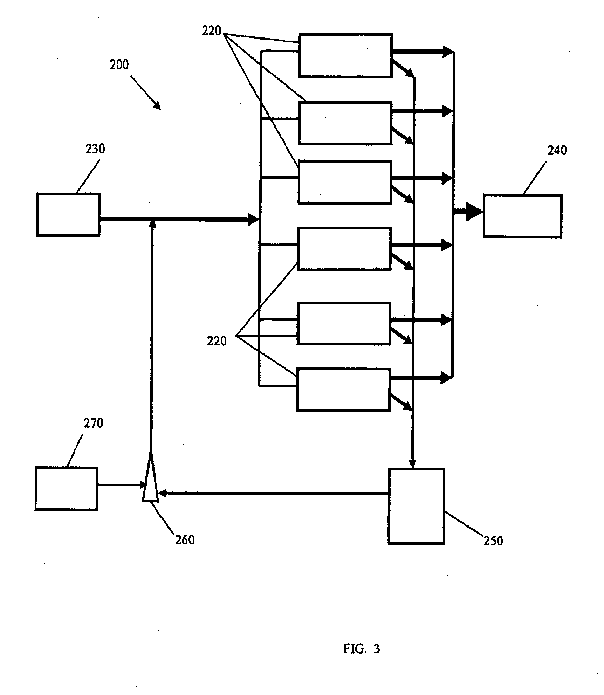

Figure 3 is a schematic view of a multi chamber PECVD system 200, for manufacturing solar cells in accordance with one embodiment of the present invention. The system 200, may be nearly identical to the system depicted in Figure 2. In this embodiment, the system 200, includes multiple deposition chambers 220, that each receive process gas, e.g. silane, silane/hydrogen mixtures, or silane mixed with other deposition gases, from a deposition gas source 230, in a particular sequence and flow pattern over time as required to deposit the desired silicon films making up the solar cell. Once again, the choice of sequence and deposition times may vary according to different manufacturing operations. At times identified in the operation when only silane or silane/hydrogen mixtures are exiting the deposition chambers 220, the off gas is sent to a collection unit 250, and then recycled for reuse in the deposition chambers 220. In this embodiment, the collected gas is delivered from the collection unit 250, back to the deposition chambers 220, using an ejector or venture device 260, that uses hydrogen from a hydrogen supply 270, as the motive force. During time periods when other gases, e.g. boron, phosphorus, carbon, etc. are present in the off gas from the deposition chambers 220, then the off gas is sent to a standard waste treatment unit 240, for disposal.

The present invention provides a number of benefits. In particular, the safe recovery and recycle of 5% to 80% of the unreacted silane or silane/hydrogen mixtures provides for reduced production costs of solar cells. Further, there is minimal process variation caused by the recycle, since the reaction by-products are in such dilute amounts that there is no impact on the quality of solar cells produced. Moreover, in the embodiment using an ejector or venturi device and hydrogen gas as the motive force, there are no moving parts and therefore low maintenance requirements.

While the methods and apparatus of the present invention have been described as being particularly applicable to the manufacture of thin film silicon layers in solar cell devices, the present invention is equally applicable to other layer depositions utilizing silane or silane/hydrogen mixtures during a least part of the deposition cycle.

It is anticipated that other embodiments and variations of the present invention will become readily apparent to the skilled artisan in the light of the foregoing description, and it is intended that such embodiments and variations likewise be included within the scope of the invention as set out in the appended claims.

## Claims

1. A method for recovering and recycling silane or silane/hydrogen mixtures from a deposition chamber used in a silicon layer deposition process, comprising:
times when only excess silane or silane/hydrogen mixtures are exiting from the deposition chamber and times when additional gases are exiting from the deposition chamber;
identifying time periods during the deposition process when only excess silane or silane/hydrogen mixtures are exiting from the deposition chamber;
collecting the silane or silane/hydrogen mixture exiting the deposition chamber during the identified time periods; and
recycling the collected silane or silane/hydrogen mixture to the deposition chamber.

2. The method of claim 1, wherein the silicon deposition process is a thin film silicon layer deposition process.

3. The method of claim 1, wherein the silicon deposition process is a solar cell manufacturing process.

4. A system for deposition of a silicon layer comprising:
a deposition chamber;
a substrate held in the deposition chamber;
a source of silane in communication with the deposition chamber;
an energy source associated with the deposition chamber for activating silane to deposit a silicon layer onto the substrate;
a collection unit communicating with the deposition chamber for collecting excess silane exiting the deposition chamber and for recycling collected silane to the deposition chamber;
means for identifying time periods during the deposition process when only excess silane or silane/hydrogen mixtures are exiting from the deposition chamber.

5. The system of claim 4, wherein the system is a system for depositing a silicon thin film.

6. The system of claim 4, wherein the system is a system for manufacturing a solar cell.

7. The system of claim 4, wherein the energy source is a thermal, microwave or plasma energy source.

8. The system of claim 4, wherein the source of silane is silane, disilane or a silane/hydrogen mixture.

9. A method of depositing a silicon layer on a substrate in a deposition chamber comprising:
during a first portions of a deposition cycle providing a source of silane to the deposition chamber to deposit a silicon layer on the substrate;
during a second portions of the deposition cycle providing a source of silane mixed with at least one other gas to the deposition chamber to deposit a mixed silicon layer on the substrate;
sending excess gas exiting the deposition chamber during the second portions of the deposition cycle to a waste disposal unit;
collecting excess silane exiting the deposition chamber during the first portions of the deposition cycle; and recycling the collected silane to the deposition chamber.

10. The method of claim 9, wherein the silicon layer is a silicon thin film.

11. The method of claim 9, wherein the silicon layer is part of a solar cell.

12. The method of claim 9, wherein the source of silane is silane, disilane or a silane/hydrogen mixture.

## Patentansprüche

1. Verfahren zum Rückgewinnen und Rückführen von Silan oder Silan-Wasserstoff-Mischungen aus einer Abscheidungskammer, die bei einem Abscheidungsprozess für eine Siliziumschicht verwendet wird, umfassend:
Zeiten, wenn nur überschüssiges Silan oder Silan-Wasserstoff-Mischungen aus der Abscheidungskammer austreten, und Zeiten, wenn zusätzliche Gase aus der Abscheidungskammer austreten;
Identifizieren von Zeitabschnitten während des Abscheidungsprozesses, wenn nur überschüssiges Silan oder Silan-Wasserstoff-Mischungen aus der Abscheidungskammer austreten;
Sammeln des Silans oder der Silan-Wasserstoff-Mischung, das/die aus der Abscheidungskammer während der identifizierten Zeitabschnitte austritt; und
Rückführen des gesammelten Silans oder der Silan-Wasserstoff-Mischung zur Abscheidungskammer.

2. Verfahren nach Anspruch 1, wobei der Siliziumabscheidungsprozess ein Dünnfilm-Siliziumschicht-Abscheidungsprozess ist.

3. Verfahren nach Anspruch 1, wobei der Siliziumabscheidungsprozess ein Solarzellen-Herstellungsprozess ist.

4. System zum Abscheiden einer Siliziumschicht, umfassend:
eine Abscheidungskammer;
ein Substrat, das in der Abscheidungskammer bereitgehalten wird;
eine Silanquelle in Kommunikation mit der Abscheidungskammer;
eine Energiequelle, die mit der Abscheidungskammer zum Aktivieren des Silans für die Abscheidung einer Siliziumschicht auf dem Substrat verbunden ist;
eine Sammeleinheit, die mit der Abscheidungskammer zum Sammeln von überschüssigem Silan, das aus der Abscheidungskammer austritt, und zum Rückführen des gesammelten Silans zur Abscheidungskammer kommuniziert;
Mittel zum Identifizieren von Zeitabschnitten während des Abscheidungsprozesses, wenn nur überschüssiges Silan oder Silan-Wasserstoff-Mischungen aus der Abscheidungskammer austreten.

5. System nach Anspruch 4, wobei das System ein System zum Abscheiden eines Siliziumdünnfilms ist.

6. System nach Anspruch 4, wobei das System ein System zum Herstellen einer Solarzelle ist.

7. System nach Anspruch 4, wobei die Energiequelle eine thermische, Mikrowellen- oder Plasma-Energiequelle ist.

8. System nach Anspruch 4, wobei die Quelle von Silan Silan, Disilan oder eine Silan-Wasserstoff-Mischung ist.

9. Verfahren zum Abscheiden einer Siliziumschicht auf einem Substrat in einer Abscheidungskammer, umfassend:
während erster Abschnitte eines Abscheidungszyklus, Bereitstellen einer Silanquelle für die Abscheidungskammer, um eine Siliziumschicht auf dem Substrat abzuscheiden;
während zweiter Abschnitte des Abscheidungszyklus, Bereitstellen einer Silanquelle, gemischt mit mindestens einem anderen Gas für die Abscheidungskammer, um eine gemischte Siliziumschicht auf dem Substrat abzuscheiden;
Leiten von überschüssigem Gas, das aus der Abscheidungskammer während der zweiten Abschnitte des Abscheidungszyklus austritt, zu einer Entsorgungseinheit;
Sammeln von überschüssigem Silan, das aus der Abscheidungskammer während der ersten Abschnitte des Abscheidungszyklus austritt; und Rückführung des gesammelten Silans zur Abscheidungskammer.

10. Verfahren nach Anspruch 9, wobei die Siliziumschicht ein Siliziumdünnfilm ist.

11. Verfahren nach Anspruch 9, wobei die Siliziumschicht Teil einer Solarzelle ist.

12. Verfahren nach Anspruch 9, wobei die Quelle von Silan Silan, Disilan oder eine Silan-Wasserstoff-Mischung ist.

## Revendications

1. Procédé de récupération et de recyclage de silane ou de mélanges silane/hydrogène à partir d'une chambre de dépôt utilisée dans un procédé de dépôt d'une couche de silicium, comprenant:
des moments où seuls du silane ou des mélanges silane/hydrogène en excès sortent de la chambre de dépôt et des moments où des gaz supplémentaires sortent de la chambre de dépôt;
l'identification de périodes de temps pendant le procédé de dépôt où seuls du silane ou des mélanges silane/hydrogène en excès sortent de la chambre de dépôt;
la collecte du silane ou du mélange silane/hydrogène sortant de la chambre de dépôt pendant les périodes de temps identifiées; et
le recyclage du silane ou du mélange silane/ hydrogène collecté dans la chambre de dépôt.

2. Procédé selon la revendication 1, dans lequel le procédé de dépôt de silicium est un procédé de dépôt d'une couche de silicium en film mince.

3. Procédé selon la revendication 1, dans lequel le procédé de dépôt de silicium est un procédé de fabrication d'une cellule solaire.

4. Système pour le dépôt d'une couche de silicium, comprenant :
une chambre de dépôt;
un substrat maintenu dans la chambre de dépôt ;
une source de silane en communication avec la chambre de dépôt;
une source d'énergie associée à la chambre de dépôt pour activer le silane afin de déposer une couche de silicium sur le substrat;
une unité de collecte communiquant avec la chambre de dépôt pour collecter le silane en excès sortant de la chambre de dépôt et pour recycler le silane collecté dans la chambre de dépôt; et
un moyen pour identifier des périodes de temps pendant le procédé de dépôt où seuls du silane ou des mélanges silane/hydrogène en excès sortent de la chambre de dépôt.

5. Système selon la revendication 4, le système étant un système pour déposer un film mince de silicium.

6. Système selon la revendication 4, le système étant un système pour fabriquer une cellule solaire.

7. Système selon la revendication 4, dans lequel la source d'énergie est une source d'énergie thermique, à micro-ondes ou à plasma.

8. Système selon la revendication 4, dans lequel la source de silane est le silane, le disilane ou un mélange silane/hydrogène.

9. Procédé de dépôt d'une couche de silicium sur un substrat dans une chambre de dépôt, comprenant:
pendant des premières parties d'un cycle de dépôt, l'introduction d'une source de silane dans la chambre de dépôt pour déposer une couche de silicium sur le substrat;
pendant des deuxièmes parties du cycle de dépôt, l'introduction d'une source de silane mélangé à au moins un autre gaz dans la chambre de dépôt pour déposer une couche de silicium mixte sur le substrat;
l'envoi du gaz en excès sortant de la chambre de dépôt pendant les deuxièmes parties du cycle de dépôt à une unité d'élimination des déchets;
la collecte du silane en excès sortant de la chambre de dépôt pendant les premières parties du cycle de dépôt; et
le recyclage du silane collecté dans la chambre de dépôt.

10. Procédé selon la revendication 9, dans lequel la couche de silicium est un film mince de silicium.

11. Procédé selon la revendication 9, dans lequel la couche de silicium fait partie d'une cellule solaire.

12. Procédé selon la revendication 9, dans lequel la source de silane est le silane, le disilane ou un mélange silane/hydrogène.
